# EUROPÄISCHE PATENTANMELDUNG

(11) **EP 4 712 715 A1**
(43) Veröffentlichungstag der Anmeldung: **18.03.2026**
(21) Anmeldenummer: 24200341.6
(22) Anmeldetag: 13.09.2024
(51) Int. Cl.: H05K 13/04, H05K 13/08

(54) **VERFAHREN ZUM BESTIMMEN DER PRÄZISION EINER AUSGABEVORRICHTUNG EINER FERTIGUNGSANLAGE, MESSEINHEIT ZUM BESTIMMEN EINER PRÄZISION UND COMPUTERPROGRAMM**

(71) Anmelder: Siemens Aktiengesellschaft, 80333 München (DE)
(72) Erfinder: Hellner, Luca-Julien, 15344 Strausberg (DE); Jarchoff, Kay, 16567 Schönfließ (DE); Sommerfeld, Dennis, 12347 Berlin (DE); Timur, Mert Serdal, 14052 Berlin (DE); Wittreich, Ulrich, 16727 Velten (DE); Wormuth, Dirk, 12203 Berlin (DE)
(74) Vertreter: Siemens Patent Attorneys

(57) **Zusammenfassung**

Die Erfindung betrifft ein Verfahren zum Bestimmen der Präzession einer Ausgabevorrichtung (12) einer Fertigungsanlage (16). Ferner betrifft die Erfindung ein Messeinheit (10) zum Bestimmen einer Präzession und ein Computerprogramm.

## Beschreibung

Die Erfindung betrifft ein Verfahren zum Bestimmen der Präzision einer Ausgabevorrichtung, insbesondere eines Dispensers, einer Fertigungsanlage und durch welche ein Fügematerial, insbesondere ein Fluid und/oder eine Suspension, auf eine Oberfläche eines Substrats appliziert wird beziehungsweise applizierbar ist, gemäß dem Patentanspruch 1. Ferner betrifft die Erfindung eine Messeinheit zum Bestimmen einer Präzision einer Ausgabevorrichtung gemäß dem Patentanspruch 9. Schließlich betrifft die Erfindung ein Computerprogramm gemäß dem Patentanspruch 11.

In SMT-Fertigungslinien (SMT: Surface Mount Technology, Oberflächenmontagetechnik) beziehungsweise Fertigungsanlagen erfolgt eine Applikation von Füllmaterialien, dem Fluid und/oder der Suspension, auf Substrate, wie beispielsweise Bedruckstoffen, insbesondere Leiterplatten (PCB: Printed Circuit Boards), unter anderem mit Hilfe eines Zeit-Druck-Dispensers. Bei diesem wird ein Druckventil verwendet, um eine mit Fügematerial gefüllte Kartusche über einen Schlauch und eine Nadel mit Druck zu versorgen. Das Füllmaterial kann somit während eines definierten Zeitraums in Tropfen- und/oder Linienform aus der Nadel austreten und fixiert so Bauelemente, insbesondere SMD-Bauteile (SMD: Surface Mounted Device).

Zusätzlich zu dem Zeit-Druck-Dispenser existieren weitere Dispersionsverfahren. So kann eine Schraubenspindel eingesetzt werden, bei der durch gesteuerte Schraubendrehungen und Druckbeaufschlagungen das Medium beziehungsweise das Fügematerial über eine Nadel zum gewünschten Ort transportiert beziehungsweise dort appliziert wird. Ein weiteres Dispersionsverfahren kann mittels des Jet-Dispensers realisiert werden, bei dem das druckbehaftete Füllmaterial in einer Kartusche mit Hilfe eines Piezoaktors mit hoher Frequenz dispenst. Dabei kann durch ein Programmieren von Dosierzeiten und Positionsbeziehungsweise Verfahrmustern das Medium beziehungsweise das Fügematerial automatisiert aufgebracht werden.

Bei der Verwendung der genannten Dispensierverfahren in Kombination mit einer SMT-Fertigungslinie beziehungsweise einer Fertigungsanlage stellen insbesondere Fehlerpositionierungen der Nadel typische Fehlerquellen dar. Bei dem Jet-Dispenser-Verfahren können Fehler insbesondere aufgrund einer fehlerhaften Ausstoßrichtung auftreten. Die genannten Fehlerquellen können zu unerwünschten Medienaufträgen und darüber hinaus sogar zu Schäden auf der Leiterplatte beziehungsweise dem PCB führen. Darüber hinaus können Schwankungen de Materialmengen auftreten.

Eine präzise Kontrolle dieser Parameter, also dem Materialauftrag, der Auftragsrichtung und dergleichen ist essenziell für einen zuverlässigen Dispensierprozess. Eine reproduzierbare Applikation des Fügematerials hinsichtlich Position und/oder Menge ist für einen qualitativ hochwertigen Fügeprozess unabdingbar.

Aktuelle Überprüfungsmöglichkeiten zur Realisierung der Dosierungspräzision sind begrenzt. Die DE 10 2016 113 432 A1 zeigt ein Messverfahren für Sieb- und Schablonendrucker mittels einer unterhalb der Druckebene angeordnete Messeinrichtung, wobei die Messeinrichtung mittels einer Kameraeinheit mindestens zwei Markierungen auf einer in der Position des Druckobjekts angeordneten Messplatte in Relation zur korrespondierenden Bezugsmarkierung auf einer auf der Messplatte anliegenden Druckform erfasst.

Aufgabe der vorliegenden Erfindung ist es, eine insbesondere in-situ Evaluierung der Dosierungspräzision und somit beispielsweise einer Transfereffizienz für Fügematerial im Rahmen von Qualitätssicherungsmaßnahmen durch ein Verfahren, eine Messeinheit und ein Computerprogramm bereitzustellen.

Diese Aufgabe wird erfindungsgemäß durch die Gegenstände der unabhängigen Patentansprüche gelöst. Vorteilhafte Ausgestaltungen und Weiterbildungen der Erfindung sind Gegenstände abhängiger Patentansprüche, der Beschreibung sowie der Zeichnung.

Ein erster Aspekt der Erfindung betrifft ein Verfahren zum Bestimmen der Präzision einer Ausgabevorrichtung, durch welche ein Fügematerial - ein Fluid und/oder eine Suspension - auf eine Oberfläche eines Substrats aufgetragen beziehungsweise appliziert wird. Dabei ist die Ausgabevorrichtung Teil einer Fertigungsanlage, die eine Aufnahme beziehungsweise ein Aufnahmeelement aufweist, durch welches das Substrat zum Applizieren in einem Applikationsbereich fixiert wird. Das erfindungsgemäße Verfahren zum Bestimmen der Präzision einer Ausgabevorrichtung erfolgt mittels einer Messeinheit und mit den folgenden Schritten:
In einem ersten Schritt erfolgt ein Fixieren der Messeinheit mittels des Aufnahmeelements in dem Applikationsbereich.

In einem zweiten Schritt erfolgt ein Positionieren eines Ausgabeelements, beispielsweise einer Nadel, der Ausgabevorrichtung relativ zu einer Applikationsoberfläche der Messeinheit.

In einem dritten Schritt erfolgt ein Aufbringen des Fügematerials auf der Applikationsoberfläche durch das Ausgabeelement. Ferner erfolgt insbesondere ein Wegbewegen des Ausgabeelements nach dem Applizieren beziehungsweise Aufbringen.

In einem vierten Schritt erfolgt ein Erstellen einer insbesondere zweidimensionalen Aufnahme, insbesondere in Form eines unkomprimierten Rohbilds, insbesondere zumindest eines Teilbereichs der Applikationsoberfläche mit einer Sensoreinheit, die mit der Applikationsoberfläche korrespondiert beziehungsweise zu dieser entsprechend für die Aufnahme angeordnet ist.

In einem fünften Schritt erfolgt ein Ermitteln wenigstens eines Ist-Zustands wenigstens eines Bereichs, in welchem das Fügematerial auf die Applikationsoberfläche aufgetragen ist.

In einem sechsten Schritt erfolgt ein Abgleich des Ist-Zustands mit einem Soll-Zustand beziehungsweise insbesondere ein Auswerten der Abweichung vom Ist- zum Soll-Zustand zum Bestimmen einer Zielwertabweichung der Ausgabevorrichtung. Insbesondere erfolgt hier das Bestimmen der Zielwertabweichung.

Bei dem Fügematerial handelt es sich um ein Fluid und/oder eine Suspension. Als Fluid werden Substanzen bezeichnet, die sich unter dem Einfluss von Scherkräften kontinuierlich verformen, das heißt sie fließen. Hier bezieht sich Fluid insbesondere auf Flüssigkeit unabhängig von ihrer Viskosität. Eine Suspension ist ein heterogenes Stoffgemisch aus einer Flüssigkeit und darin fein verteilten Festkörpern (Partikeln), daher kann nach strömungsmechanischer Definition auch eine Suspension als Fluid betrachtet werden. Somit werden im Folgenden die Begriffe Fügematerial und Fluid synonym verwendet und schließen eine Suspension ein.

Bei Ausgabevorrichtung handelt es sich insbesondere um einen Dispenser beziehungsweise um eine Dispenservorrichtung, wie beispielsweise einen Zeit-Druck-Dispenser. Das Ausgabeelement, insbesondere eine Nadel der Dispenseinrichtung, kann bei der Positionierung beziehungsweise bei dem Verfahren insbesondere über der Sensoreinheit, welcher sich vorteilhafterweise unterhalb der Applikationsoberfläche befindet, positioniert werden. Der Applikationsbereich ist insbesondere ein Fertigungsabschnitt, in welchem das Applizieren des Fügematerials im Regelfall auf einem Substrat, wie einer Leiterplatte beziehungsweise ein PCB, erfolgt. Die Sensoreinheit ist beispielsweise als kapazitiver Sensor ausgebildet und kann somit über durch Fügematerial induzierte Kapazitätsänderungen Bereiche unterscheiden, auf welchen das Fügematerial aufgetragen ist oder nicht. Bei dem Fügematerial handelt es sich insbesondere um ein Fluid und somit um ein im Wesentlichen flüssiges Material. Zusätzlich oder alternativ ist das Füllmaterial eine Suspension und somit insbesondere ein pastöses Material, in welches in einer Flüssigkeit ein hoher Feststoffanteil eingebracht ist. Der wenigstens eine Ist-Zustand beziehungsweise der wenigstens eine Soll-Zustand beschreiben beispielsweise eine Kontur des Bereichs, und somit insbesondere eine Struktur der aufgetragenen Fügematerialschicht, und/oder deren Position. Darüber hinaus kann die Art und/oder Menge einer Dosierung des Fügematerials durch den jeweiligen Zustand beschrieben werden. Das Ermitteln des wenigstens einen Ist-Zustands und der Abgleich mit dem Soll-Zustand wird insbesondere durch eine Auswerteeinheit, welche beispielsweise eine Komponente einer Steuereinheit ist, welche beispielsweise als elektronische Recheneinrichtung ausgebildet sein kann, durchgeführt.

Mit anderen Worten erfolgt die Validierung der Dosierungspräzision über einen Sensor, insbesondere einem kapazitiven Sensor. Dabei wird beispielsweise eine diskrete Anzahl von Kondensatorzellen in Form einer Matrix verwendet, um den lokalen Auftrag des Fluids oder der Suspension zu detektieren. Durch den Auftrag des zu untersuchenden Fluids beziehungsweise der Suspension ändert sich die elektrische Ladung an entsprechenden Kondensatorzellen der Matrix beziehungsweise des Arrays, was erfasst und dadurch die Aufnahme zusammengesetzt beziehungsweise erstellt werden können. Dabei können insbesondere die Schritte 3 bis 6 des Verfahrens als ein Algorithmus aufgefasst werden, welcher insbesondere Parallelen zu einer Computer Vision aufweist und der zur automatisierten Präzisionsidentifikation dient. Alternativ könnte die entsprechende Evaluierung auch durch einen Benutzer mit Hilfe einer konventionellen Bildverarbeitungssoftware durchgeführt werden. Die Aufnahmen als Grundlage für eine Messdatenverarbeitung sind dabei insbesondere unkomprimierte Rohbilddaten.

Die ermittelten Abweichungen können in Abhängigkeit von gegebenenfalls variierenden Umgebungsbedingungen erfasst werden. Die Auswertung der Abweichung umfasst insbesondere die Ermittlung von Mittelwerten und Standardabweichungen. Die Auswertung der Abweichungen ermöglicht die Erfassung insbesondere druckmaschinenbedingter, das heißt ausgabevorrichtungsbedingter, systematischer Fehler. Aus den Abweichungen können entsprechende Maschinenfähigkeitswerte, Kalibrierwerte beziehungsweise Korrekturwerte, insbesondere beispielsweise auf der Oberfläche und somit insbesondere in x- und y-Richtung, sowie hinsichtlich eines Verdrehwinkels, bestimmt werden. Zusätzlich dazu kann die Auswertung eine graphische Darstellung zur Veranschaulichung der Abweichung in der Kontur liefern. Abweichungen können in Prozent im Kontext von implementierten Idealgeometrien beziehungsweise Soll-Geometrien interpretiert werden.

Durch das Verfahren ergibt sich der Vorteil einer besonders präzisen Bestimmung der Präzision der Ausgabevorrichtung.

In vorteilhafter Ausgestaltung der Erfindung wird für das Ermitteln des wenigstens einen Ist-Zustands eine Kontur des Bereichs approximiert und/oder ein Mittelpunkt und/oder ein Flächenschwerpunkt bestimmt. Mit anderen Worten wird anhand der Aufnahme zuerst versucht, die erfasste Kontur in dem wenigstens einen Bereich zu approximieren und anschließend einen insbesondere idealisierten Mittelpunkt der Kontur, welcher auch einen Flächenschwerpunkt der Kontur darstellen kann, zu bestimmen. Dadurch ergibt sich der Vorteil, dass die Zielwertabweichung besonders vorteilhaft ermittelt werden kann.

In weiterer vorteilhafter Ausgestaltung der Erfindung wird für das Ermitteln des wenigstens einen Ist-Zustands die Pose, also insbesondere die Position und/oder die Lage der Messeinheit, in dem Applikationsbereich insbesondere präzise erfasst, wodurch aus dem Ist-Zustand insbesondere ein Soll-Zustand abgeleitet werden kann. Mit anderen Worten werden durch eine präzise Positionierung und Erfassung der Messeinheit im Fertigungsabschnitt beispielsweise eine Soll-Dosierung, eine Soll-Nadelposition und/oder eine Soll-Mittelwertposition festgelegt. Dadurch ergibt sich der Vorteil, dass das Verfahren besonders präzise durchgeführt werden kann.

In weiterer vorteilhafter Ausgestaltung der Erfindung wird durch die Pose der wenigstens eine Soll-Zustand festgelegt. Mit anderen Worten kann anhand der genauen Kenntnis über die Positionierung der Messeinheit beziehungsweise insbesondere deren Applikationsoberfläche, auf welcher analog zu der Oberfläche des Substrats bei dem Verfahren Fugenmaterial appliziert wird, auf die Soll-Zustände geschlossen werden, indem entsprechend beispielsweise eine Kalibrierung des Ausgabeelements der Ausgabevorrichtung erfolgen kann. Dadurch ergibt sich der Vorteil, dass das Verfahren besonders vorteilhaft zum Prüfen der Präzision verwendet werden kann.

In weiterer vorteilhafter Ausgestaltung der Erfindung wird als die Zielwertabweichung der Ausgabevorrichtung ein insbesondere druckmaschinen- beziehungsweise dispersionsmaschinenbedingter systematischer Fehler bestimmt und/oder ein Maschinenfähigkeitswert und/oder ein Kalibrierwert und/oder ein Korrekturwert bestimmt. Mit anderen Worten dient das Verfahren dazu, Fehler der Ausgabevorrichtung aufzuspüren und diese insbesondere vor einer Serienfertigung zu korrigieren, wofür entsprechend anhand der bestimmten Abweichungen des wenigstens einen Soll-Zustands vom Ist-Zustand entsprechende druckmaschinenbedingte systematische Fehler bestimmt werden können, woraufhin auch ein Maschinenfähigkeitswert der Ausgabevorrichtung bestimmt werden kann und entsprechend Kalibrierwerte und/oder Korrekturwerte (insbesondere in X-Richtung und Y-Richtung sowie hinsichtlich des Verdrehungswinkels), um die Ausgabevorrichtung derart einzustellen beziehungsweise anzupassen, dass das Fügematerial so aufgetragen wird, dass es eine besonders geringe Abweichung vom Soll-Wert aufweist. Dadurch ergibt sich der Vorteil, dass das Verfahren insbesondere besonders vorteilhaft verwendet werden kann, um beispielsweise während einer Serienfertigung eine vorteilhafte Bauteilqualität von mittels des Fügematerials auf dem Substrat angebrachten SMD-Bauteilen zu gewährleisten.

In weiterer vorteilhafter Ausgestaltung der Erfindung erfolgt das Erstellen der Aufnahme beziehungsweise startet das Erstellen der Aufnahme durch einen Trigger beim Applizieren beziehungsweise einen Dispensauftrag. Zusätzlich oder alternativ startet das Erstellen der Aufnahme automatisiert durch Ladungsänderung eines Sensors beziehungsweise einer Sensoreinheit der Messeinheit und/oder durch ein Bedienelement, wie beispielsweise einen Taster, und/oder über ein definiertes Intervall zwischen einzelnen automatisierten Erfassungen. Mit anderen Worten startet die Datenerfassung über einen Trigger-by-Dispense-Auftrag, automatisiert durch Ladungsänderung des Arrays, über ein Bedienelement oder über automatisierte Erfassungen. Dadurch ergibt sich der Vorteil, dass das Verfahren besonders automatisiert durchgeführt werden kann.

In weiterer vorteilhafter Ausgestaltung der Erfindung erfolgt eine Auswertung des wenigstens einen erfassten dynamisch und/oder statisch. Mit anderen Worten bietet die Messeinheit die Möglichkeit der dynamischen und/oder statischen Auswertung. Das heißt, eine Auswertung während des Auftrags beziehungsweise Applizierens und/oder am Ende, nachdem das Fügematerial mit der gewünschten Kontur vollständig appliziert wird. Dadurch ergibt sich die Möglichkeit, dass das Fließverhalten eines liquiden Fluids beurteilt werden kann. Dabei können auch Abweichungen und variierende Bedingungen, wie beispielsweise der Ausbreitungsgeschwindigkeit und dem Abdampfungsgrad, erfasst und/oder ausgewertet werden, falls die dynamische Auswertung erfolgt.

Ein zweiter Aspekt der Erfindung betrifft eine Messeinheit zum Bestimmen einer Präzision einer Ausgabevorrichtung, durch welche ein Fügematerial auf einer Oberfläche eines Substrats applizierbar ist, einer Fertigungsanlage, wobei die Fertigungsanlage eine Aufnahme aufweist, durch welche das Substrat zum Applizieren in einem Applikationsbereich fixiert wird. Die erfindungsgemäße Messeinheit umfasst ein Gehäuse, das insbesondere mit der Aufnahme korrespondiert, welches von einer Applikationsoberfläche unterbrochen ist. Ferner umfasst die Messeinheit eine Sensoreinheit, durch die Aufnahmen, insbesondere in Form eines unkomprimierten Rohbilds, zumindest eines Teilbereichs der Applikationsoberfläche erstellbar sind, welche insbesondere in dem Gehäuse angeordnet sein kann, ebenso wie eine Steuereinheit, welche insbesondere einen Mikrocontroller beziehungsweise eine elektronische Recheneinrichtung umfasst, wobei die Messeinheit für eine Verwendung in einem Verfahren nach einem der vorhergehenden Ansprüche ausgebildet ist.

Die Messeinheit setzt sich mit anderen Worten somit aus einem Gehäuse zur Integration der Sensoreinheit, welche insbesondere ein modifiziertes biometrisches Authentifizierungssystem sein kann, einem Mikrocontroller, einer entsprechenden Leiterplatte und/oder einer Stromversorgung sowie zusätzlich vorteilhafterweise einem Speichermedium zusammen.

Dabei sind vorteilhafte Ausgestaltungen und Weiterbildungen sowie Vorteile des ersten Aspekts der Erfindung als vorteilhafte Ausgestaltungen, Weiterbildungen sowie Vorteile des zweiten Aspekts der Erfindung anzusehen und umgekehrt.

In vorteilhafter Ausgestaltung der Erfindung umfasst die Sensoreinheit einen kapazitiven Sensor, einen optischen Sensor, einen Ultraschallsensor und/oder einen thermischen Sensor. Zusätzlich oder alternativ ist die Sensoreinheit als Komponente für ein Authentifizierungssystem, insbesondere einen Fingerabdrucksensor, ausgebildet. Mit anderen Worten kann mittels unterschiedlicher Messverfahren mittels der Sensoreinheit die Aufnahme erstellt werden, wobei die Sensoreinheit jeweils einen entsprechenden Sensor aufweist, beispielsweise ein Array aus kapazitiven Elementen und/oder einen CCD-Sensor oder dergleichen, wodurch eine insbesondere zweidimensionale Aufnahme ermöglicht wird. Es hat sich gezeigt, dass durch die Modifikation eines Authentifizierungssystems, welches insbesondere als Fingerabdrucksensor ausgebildet ist, eine entsprechende Sensoreinheit für die Messeinheit bereitgestellt werden kann, da das Authentifizierungssystem so modifiziert werden kann, dass es für Fugenmaterial sensitiv ist. Dadurch ergibt sich der Vorteil, dass auf besonders vorteilhafte Weise Kosten gespart werden können.

In weiterer vorteilhafter Ausgestaltung der Erfindung ist eine Stromversorgung, insbesondere in Form einer Batterie, vorhanden. Zusätzlich oder alternativ ist ein Speichermedium, beispielsweise ein Speicher vorhanden, um die Aufnahme zu speichern. In weiterer vorteilhafter Ausgestaltung der Erfindung kann eine Kommunikationseinheit, insbesondere zur drahtlosen Echtzeitübertragung, wie beispielsweise ein Funkmodem, vorhanden sein. Durch die Stromversorgung kann die Messeinheit unabhängig von einer externen Stromquelle versorgt werden. Zusätzlich kann mittels eines Speichermediums auf einen externen Speicheranschluss verzichtet werden. Über die Kommunikationseinheit kann insbesondere, wenn die Messeinheit in der Aufnahme angeordnet ist, eine Datenübertragung erfolgen, beispielsweise insbesondere für die dynamische Messung beziehungsweise Auswertung. Dadurch ergibt sich der Vorteil, dass die Messeinheit besonders flexibel eingesetzt werden kann.

In weiterer vorteilhafter Ausgestaltung der Erfindung sind an dem Gehäuse zur Applikationsoberfläche korrespondiere Erkennungsmarken angeordnet sind. Diese diene dazu die Pose, also die Position und Orientierung, der Messeinheit in dem Applikationsbereich vorteilhaft zu erfassen, beispielweise mittels eine Erfassungseinheit, wie einer Kamera. Dadurch ergibt sich der Vorteil, dass die Pose der Messeinheit besonders einfach und/oder präzise ermittelt werden kann.

Ein dritter Aspekt der Erfindung betrifft ein Computerprogramm, welches direkt in einen Speicher einer Steuereinheit einer Messeinheit und/oder Fertigungsanlage ladbar ist, mit Programm-Mitteln, um die Schritte des Verfahrens gemäß dem ersten Aspekt der Erfindung auszuführen, wenn das Programm in der Steuereinheit ausgeführt wird.

Dabei sind vorteilhafte Ausgestaltungen und Weiterbildungen sowie Vorteile des zweiten Aspekts der Erfindung als vorteilhafte Ausgestaltungen, Weiterbildungen sowie Vorteile des dritten Aspekts der Erfindung anzusehen und umgekehrt.

Unabhängig vom grammatikalischen Geschlecht eines bestimmten Begriffes sind Personen mit männlicher, weiblicher oder anderer Geschlechteridentität mit umfasst.

Es zeigt:
- FIG 1: eine schematische Perspektivansicht einer Messeinheit zum Bestimmen einer Präzision einer Ausgabevorrichtung einer Fertigungsanlage; und
- FIG 2: ein schematisches Ablaufdiagramm für ein Verfahren zum Bestimmen der Präzision mittels der Messeinheit gemäß FIG 1.

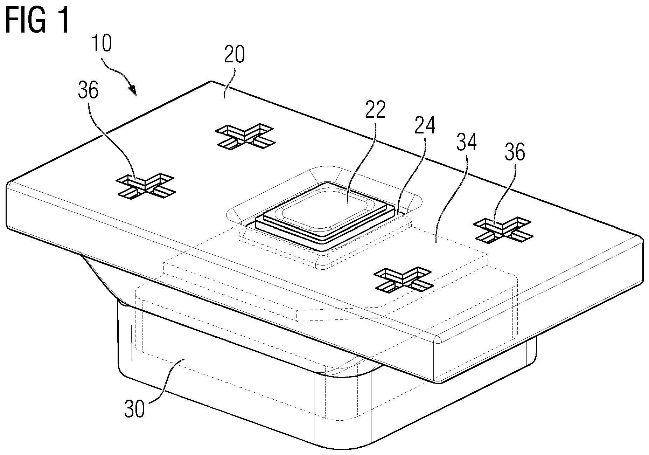

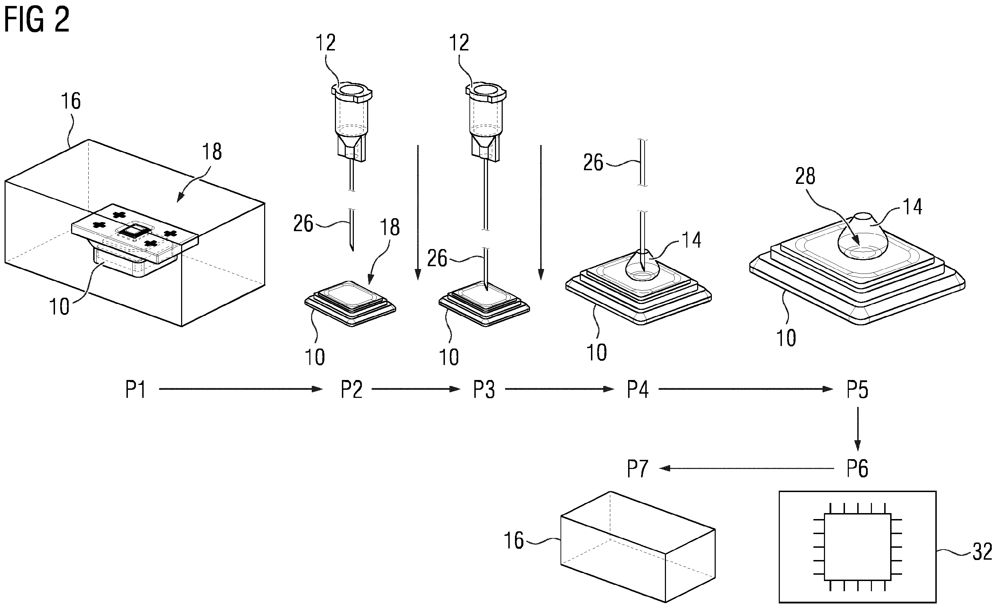

FIG 1 zeigt in einer schematischen Perspektivansicht eine Messeinheit 10 zum Bestimmen einer Präzision einer in FIG 2 gezeigten Ausgabevorrichtung 12, mit welcher ein Fügematerial 14 auf eine Oberfläche eines Substrats applizierbar ist, wobei die Ausgabevorrichtung 12 eine Komponente einer Fertigungsanlage 16 ist, welche insbesondere als SMT-Fertigungslinie ausgebildet sein kann.

Die Fertigungsanlage 16 umfasst eine Fixierung beziehungsweise ein Aufnahmeelement, durch welches das Substrat, insbesondere eine Leiterplatte beziehungsweise ein PCB zum Applizieren in einem Applikationsbereich 18 fixiert wird.

Die Messeinheit 10 umfasst ein Gehäuse 20, welches insbesondere mit der Fixierung korrespondiert und welches von einer Applikationsoberfläche 22 unterbrochen ist. Ferner umfasst die Messeinheit 10 eine Sensoreinheit 24, welche insbesondere unterhalb der insbesondere durchsichtigen beziehungsweise transparenten Applikationsoberfläche 22 in dem Gehäuse angeordnet ist und durch die eine Aufnahme, insbesondere in Form eines unkomprimierten Rohbilds, zumindest eines Teilbereichs der Applikationsoberfläche 22 erstellbar ist. Mit beispielsweise einer elektronischen Recheneinheit 32 (Komponente einer Steuereinheit) der Messeinheit 10 kann die Aufnahme verarbeitet werden beziehungsweise ist die Steuereinheit 24 dazu ausgebildet, zumindest teilweise ein Verfahren zum Bestimmen der Präzision der Ausgabevorrichtung 12 durchzuführen, wobei in dem Verfahren die Messeinheit 10 verwendet wird und das Verfahren mehrere Schritte umfasst.

Die Sensoreinheit 24 umfasst insbesondere einen kapazitiven Sensor. Zusätzlich oder alternativ kann die Sensoreinheit 24 einen optischen Sensor, einen Ultraschallsensor und/oder einen thermischen Sensor aufweisen. Dabei kann die Sensoreinheit 24 eine umgebaute Komponente eines Authentifizierungssystems, wie beispielsweise eines Fingerabdrucksensors, sein. Bei einem kapazitiven Sensor wird eine diskrete Anzahl von Kondensatorzellen in Form einer Matrix beziehungsweise eines Arrays verwendet, um das aufgetragene Fügematerial 14 zu detektieren. Das Fügematerial 14 ist insbesondere ein liquides Fluid und/oder eine Paste beziehungsweise eine Suspension darstellt. So kann beispielsweise ein Auftragen des zu untersuchenden Fügematerials 14 eine elektrische Leitfähigkeit an einzelnen Pixel beziehungsweise Kondensatorzellen des Arrays ändern, welche somit durch dieses erfasst wird. Die Messeinheit 10 weist eine Leiterplatte 34, auf welcher beispielsweise en Speicher

Vorteilhafterweise umfasst die Messeinheit 10 eine eigene Stromversorgung, wie beispielsweise eine Batterie 30. Darüber hinaus kann die Messeinheit 10 für ein vorteilhaftes selbständiges Speichern, beispielsweise der Aufnahme, ein Speichermedium umfassen und ferner über eine Kommunikationseinheit, wie beispielsweise ein Funkmodell, verfügen, welches insbesondere zur drahtlosen Echtzeitübertragung ausgebildet ist. Die Messeinheit 10 weist eine Leiterplatte 34, auf welcher beispielsweise das Speichermedium und/oder ein Mikrocontroller, der beispielsweise die elektronischen Recheneinheit 32 bilden kann, auf. Ferner kann das Gehäuse Erkennungsmarken 36 aufweisen. Mittels diese kann die Pose der Messeinheit 10 besonders einfach und/oder präzise ermittelt werden.

Die Schritte des Verfahrens zum Bestimmen der Präzision einer Ausgabevorrichtung 12 mittels der Messeinheit 10 sind:
Ein erster Schritt ist ein Fixieren der Messeinheit mittels der Fixierung beziehungsweise des Aufnahmeelements in dem Applikationsbereich 18.

In einem zweiten Schritt erfolgt ein Positionieren eines Ausgabeelements 26, insbesondere einer Nadel, der Ausgabevorrichtung 12, welche insbesondere als Dispenser ausgebildet ist, relativ zu einer Applikationsoberfläche 22 der Messeinheit 10.

Der dritte Schritt ist ein Aufbringen des Fügematerials 14 auf den Applikationsbereich 18 durch das Ausgabeelement 26 und insbesondere nach dem Applizieren ein Wegbewegen des Ausgabeelements 26.

In einem vierten Schritt erfolgt ein Erstellen einer insbesondere zweidimensionalen Aufnahme beziehungsweise des unkomprimierten Rohbilds der Applikationsoberfläche 22 mit der Sensoreinheit 24, die mit der Applikationsoberfläche 22 korrespondiert beziehungsweise entsprechend zum Erstellen der Aufnahme an dieser zum Abbilden selbiger angeordnet ist. Mit anderen Worten ist ein Sensorbereich der Sensoreinheit 24 entsprechend angeordnet ist.

In einem fünften Schritt erfolgt ein Ermitteln wenigstens eines Ist-Zustands, beispielsweise einer Kontur einer Position und/oder einer Lage, wenigstens eines Bereichs 28, in welchem das Fügematerial 14 auf die Applikationsoberfläche 22 aufgetragen ist, beziehungsweise entsprechend in dem dritten Schritt appliziert beziehungsweise aufgetragen wurde.

Schließlich erfolgt in einem weiteren Schritt erfolgt ein Abgleich des Ist-Zustands mit einem Soll-Zustand zum Bestimmen einer Zielwertabweichung der Ausgabevorrichtung 12, wobei das Bestimmen in der Regel mit durchgeführt wird. Anhand der bestimmten Zielwertabweichung können vorteilhaft Schlussfolgerungen für einen Betreib, insbesondere Serienbetrieb, der Fertigungsanlage 16 abgeleitet werden.

FIG 2 zeigt das Verfahren beziehungsweise dessen Schritte in einer möglichen Abfolge. So erfolgt unter Punkt P1 eine Einfuhr, wobei die Messeinheit 10 der Fertigungsanlage 16 zugeführt wird, wobei anschließend erforderliche Maschineneinstellungen durchgeführt werden, sodass die Messeinheit 10 erfasst und beispielsweise die Soll-Positionen ermittelt werden können.

In Punkt P2 erfolgt ein Anfahren, das heißt die Nadel der Dispenseinrichtung, also das Ausgabeelement 26 der Ausgabevorrichtung, 12 wird über den Sensor beziehungsweise die Sensoreinheit 24 positioniert. Ferner wird der Dispensvorgang für das Fügematerial 14 vorbereitet.

In Punkt P3 erfolgt ein Herunterfahren. Die Nadel der Dispenseinrichtung wird zum Ausführen des Medienauftrags beziehungsweise zum Auftragen des Fügematerials 14 insbesondere unmittelbar oberhalb des Sensors beziehungsweise der Sensoreinheit 24 abgesenkt.

In Punkt P4 erfolgt der Medienauftrag, wobei eine Applikation einer diskreten Medienmenge beziehungsweise des Fügematerials 14 erfolgt.

In Punkt P5 erfolgt eine Finalisierung, das heißt der Dispensvorgang wird abgeschlossen, die Nadel der Dispenseinrichtung kehrt in ihren Ausgangszustand zurück.

In Punkt P6 startet somit ein Algorithmus, welcher insbesondere auch mittels eines hier vorgestellten Computerprogramms beispielsweise auf einer Steuereinheit beziehungsweise einer elektronische Recheneinrichtung 32 ausgeführt werden kann. Dabei kann der Algorithmus beispielsweise durch einen Trigger eine Ladungsträgeränderung und/oder einen dynamischen Trigger beispielsweise aufgrund eines Intervalls gestartet werden, sodass die Auswertung und dabei das Ermitteln einer Abweichung vom Ist-Zustand zum Soll-Zustand erfolgt.

Dabei kann beispielsweise an den Rohbilddaten eine Konturapproximation erfolgen, woraus ein idealisierter Mittelpunkt bestimmt wird. Aus dem idealisierten Mittelpunkt kann ein Ermitteln der relativen Zielwertabweichung erfolgen, anhand deren Auswertung beispielsweise Korrekturwerte ermittelt werden und der Ausgabevorrichtung 12 beziehungsweise der Fertigungsanlage 16 übermittelt beziehungsweise dort eingestellt werden können.

Schließlich erfolgt in Punkt P7 die Ausfuhr der Messeinheit 10 aus dem Applikationsbereich 18 der Fertigungsanlage 16.

Zusammengefasst erfolgt bei dem Verfahren die Validierung einer Dosierpräzision mittels eines kapazitiven Sensors, wobei zur vereinfachten Umsetzung beziehungsweise zur Kostenreduktion ein Authentifizierungssystem so modifiziert werden kann, dass es für die Bestimmung der Bereiche 28 von liquiden Fluiden beziehungsweise Pasten anwendbar ist. Insbesondere durch das Computerprogramm beziehungsweise das Verfahren erfolgt die Evaluierung analog eines Bildextraktors für eine automatisierte Präzisionsidentifikation, wobei die Grundlage für eine Messdatenverarbeitung anhand der unkomprimierten Rohbilddatei beziehungsweise der Aufnahme erfolgt. Dabei nutzt der Algorithmus Parameter, um zunächst die erfasste Kontur zu approximieren und anschließend einen möglichen Mittelpunkt zu berechnen. Durch präzise Positionierung und Erfassung der Messeinheit 10 im Fertigungsabschnitt beziehungsweise Applikationsbereich 18 werden Soll-Dosierung, Soll-Nadelposition und Soll-Mittelwertposition festgelegt. Diese fungieren als Referenz zur Ist-Erfassung, die aus den unkontrollierten Rohbilddateien resultiert. Somit wird eine Bewertung der relativen Zielwertabweichung ermöglicht. Eine manuelle Auswertung kann nach dem gleichen Grundprinzip erfolgen.

Die ermittelten Abweichungen können in Abhängigkeit der gegebenenfalls variierenden Umgebungsbedingungen erfasst werden. Die Auswertung der Abweichung umfasst die Ermittlung von Mittelwerten und Standardabweichungen. Die Auswertung der Abweichungen ermöglicht die Erfassung druckmaschinenbedingter systematischer Fehler. Aus den Abweichungen können entsprechende Maschinenfähigkeitswerte, Kalibrierwerte beziehungsweise Korrekturwerte in x- und y-Richtung sowie hinsichtlich eines Verdrehwinkels bestimmt werden. Der Verdrehwinkel ergibt sich, wenn die Ausgabevorrichtung 12 in dem Applikationsbereich 18 gegenüber dem Substrat beziehungsweise der Leiterplatte, auf welche aufgetragen werden soll, verdreht ist.

Zusätzlich dazu kann anhand der Auswertung eine graphische Darstellung gebildet werden, welche insbesondere zum Veranschaulichen der Abweichung der Kontur dient. Abweichungen können beispielsweise in Prozent im Kontext von implementierten Idealgeometrien interpretiert werden.

Dabei kann die Datenerfassung, wie bereits erwähnt über einen Trigger beim Dispensauftrag erfolgen und/oder automatisiert durch Ladungsänderung des Arrays und/oder durch einen Taster oder Ähnliches und/oder über ein definiertes Intervall zwischen einzelnen automatisierten Erfassungen. Die Messeinheit 10 bietet die Möglichkeit der dynamischen und statischen Auswertung. Folglich kann das Fließverhalten des liquiden Fluids bei der algorithmusbasierten Auswertung nach analogem Vorgehen bei Messdatenverarbeitung beurteilt werden.

Dabei ist ein wesentlicher Unterschied zum Stand der Technik die Methodik, die insbesondere auf einen kapazitiven Sensor setzt und beispielsweise keines triangulatorischen Messprinzips bedarf. Durch die Sensoreinheit 24 beziehungsweise die Messeinheit 10 wird eine Änderung der elektrischen Ladung der Matrix erfasst. Dabei können auch Abweichungen unter variierenden Bedingungen, wie beispielsweise die Ausbreitungsgeschwindigkeit und der Abdampfungsgrad, erfasst beziehungsweise ausgewertet werden.

Ein hierin beschriebenes Verfahren kann auch in Form eines Computerprogramms vorliegen, das das Verfahren auf einer elektronischen Recheneinrichtung 32 implementiert, wenn es auf dieser ausgeführt wird. Ebenso kann ein elektronisch lesbarer Datenträger (nicht dargestellt) mit darauf gespeicherten elektronisch lesbaren Steuerinformationen vorliegen, welche zumindest ein beschriebenes Computerprogrammprodukt umfassen und derart ausgestaltet sind, dass sie bei Verwendung des Datenträgers in einer elektronischen Recheneinrichtung 32 ein beschriebenes Verfahren durchführen.

Somit sind hier sowohl ein Verfahren, eine Messeinheit 10 als auch ein Computerprogramm zur Validierung der Dosierpräzision eines Dispensers beziehungsweise der Ausgabevorrichtung 12 dargestellt.

### Bezugszeichenliste

- 10: Messeinheit
- 12: Ausgabevorrichtung
- 14: Fügematerial
- 16: Fertigungsanlage
- 18: Applikationsbereich
- 20: Gehäuse
- 22: Applikationsoberfläche
- 24: Sensoreinheit
- 26: Ausgabeelement
- 28: Bereich
- 30: Stromversorgung
- 32: elektronische Recheneinrichtung
- 34: Leiterplatte
- 36: Erkennungsmarke

## Patentansprüche

1. Verfahren zum Bestimmen der Präzision einer Ausgabevorrichtung (12), durch welche ein Fügematerial (14) auf eine Oberfläche eines Substrats appliziert wird, einer Fertigungsanlage (16), die ein Aufnahmeelement aufweist, durch welche das Substrat zum Applizieren in einem Applikationsbereich (22) fixiert wird, mittels einer Messeinheit (10) und mit den Schritten:
- Fixieren der Messeinheit (10) mittels des Aufnahmeelements in dem Applikationsbereich (18);
- Positionieren eines Ausgabeelements (26) der Ausgabevorrichtung (30) relativ zu einer Applikationsoberfläche (22) der Messeinheit (10);
- Aufbringen des Fügematerials (14) auf der Applikationsoberfläche (22) durch das Ausgabeelement (26);
- Erstellen einer Aufnahme der Applikationsoberfläche (22) mit einer Sensoreinheit (24), die mit der Applikationsoberfläche (22) korrespondiert;
- Ermitteln wenigstens eines Ist-Zustands wenigstens eines Bereichs, in welchem das Fügematerial (14) auf die Applikationsoberfläche (22) aufgetragen ist; und
- Abgleich des Ist-Zustands mit einem Soll-Zustand zum Bestimmen einer Zielwertabweichung der Ausgabevorrichtung.

2. Verfahren nach Anspruch 1, **dadurch gekennzeichnet, dass**
für das Ermitteln des wenigstens eine Ist-Zustands eine Kontur des Bereichs approximiert wird und/oder eine Mittelpunkt und/oder Flächenschwerpunkt bestimmt werden.

3. Verfahren nach Anspruch 1 oder 2, **dadurch gekennzeichnet, dass**
für das Ermitteln des wenigstens einen Ist-Zustands die Pose der Messeinheit (10) in dem Applikationsbereich (18) erfasst wird.

4. Verfahren nach Anspruch 3, **dadurch gekennzeichnet, dass**
durch die Pose der wenigstens einen Soll-Zustand festgelegt wird.

5. Verfahren nach einem der vorhergehenden Ansprüche, **dadurch gekennzeichnet, dass** als die Zielwertabweichung der Ausgabevorrichtung (12) ein systematischer Fehler und/oder ein Maschinenfähigkeitswert und/oder ein Kalibrierwert und/oder ein Korrekturwert bestimmt werden.

6. Verfahren nach einem der vorhergehenden Ansprüche, **dadurch gekennzeichnet, dass** das Erstellen der Aufnahme durch einen Trigger beim Applizieren und/oder automatisiert durch Ladungsänderung an der Messeinheit und/oder durch ein Bedienelement und/oder über einen definierten Intervall zwischen einzelnen automatisierten Erfassungen erfolgt.

7. Verfahren nach einem der vorhergehenden Ansprüche, **dadurch gekennzeichnet, dass** eine Auswertung des wenigstens einen erfassten Bereichs dynamisch und/oder statisch erfolgt.

8. Messeinheit (10) zum Bestimmen einer Präzision einer Ausgabevorrichtung (12), durch welche ein Fügematerial (14) auf eine Oberfläche eines Substrat applizierbar ist, einer Fertigungsanlage (16), die ein Aufnahmeelement aufweist, durch welche das Substrat zum Applizieren in einem Applikationsbereich (18) fixiert wird, und mit einem Gehäuse (20), welches von einer Applikationsoberfläche (22) unterbrochen ist, mit einer Sensoreinheit (24), durch die eine Aufnahme der Applikationsoberfläche (22) erstellbar ist und mit einer Steuereinheit (24), wobei die Messeinheit (10) für eine Verwendung in einem Verfahren nach einem der vorhergehenden Ansprüche ausgebildet ist.

9. Messeinheit (10) nach Anspruch 8, **dadurch gekennzeichnet, dass**
die Sensoreinheit (24) einen kapazitiven Sensors, einen optischen Sensors, einen Ultraschallsensors und/oder eines thermischen Sensors aufweist und/oder als Komponente für ein Authentifizierungssystem ausgebildet ist.

10. Messeinheit (10) nach einem der Ansprüche 6 bis 8, **dadurch gekennzeichnet, dass** ein Stromversorgung (30) und/oder ein Speichermedium und/oder eine Kommunikationseinheit vorhanden ist.

11. Messeinheit (10) nach Anspruch 8, **dadurch gekennzeichnet, dass**
an dem Gehäuse (20) zur Applikationsoberfläche (22) korrespondiere Erkennungsmarken (36) angeordnet sind.

12. Computerprogramm, welches direkt in einen Speicher einer Steuereinheit einer Messeinheit (10) und/oder Fertigungsanlage (16) ladbar ist, mit Programm-Mitteln, um die Schritte des Verfahrens nach einem der Ansprüche 1 bis 7 auszuführen, wenn das Programm in der Steuereinheit ausgeführt wird.
